Europäisches Patentamt

European Patent Office

Office européen des brevets

(11) Publication number : 0 505 176 A1

# (12) EUROPEAN PATENT APPLICATION

(21) Application number : 92302367.5

(22) Date of filing : 19.03.92

(51) Int. Cl.⁵ : H01L 29/86

(30) Priority : 22.03.91 GB 9106205

(43) Date of publication of application :
23.09.92 Bulletin 92/39

(84) Designated Contracting States :
DE ES FR GB IT

(71) Applicant : LUCAS INDUSTRIES PUBLIC
LIMITED COMPANY
Brueton House, New Road
Solihull, West Midlands B91 3TX (GB)

(72) Inventor : Wilson, Robin
27 Manor Avenue Bangor
County Down Northern Ireland (GB)
Inventor : Gamble, Harold Samuel
16 Ireland Hill Dromare Road Dromare
County Down Northern Ireland (GB)

(74) Representative : Gibson, Stewart Harry
URQUHART-DYKES & LORD Business
Technology Centre Senghennydd Road
Cardiff CF2 4AY South Wales (GB)

(54) Breakover diode.

(57) A breakover diode comprises a thyristor formed by an anode region (12), an anode base region (11), a cathode base region (15) and a cathode region (18) disposed between anode and cathode electrodes (13,21), and a trigger region (16) of the same conductivity type as the anode base region (11) but of substantially higher carrier concentration. The trigger region (16) forms junctions with the anode base region (11) and with the cathode base region (15) : the latter junction breaks down at a low voltage, to switch on a pilot thyristor section (B), which then switches on the main thyristor section (C). The device achieves a low breakdown voltage without the need for a high carrier concentration throughout the anode base region (11).

FIG. 1

This invention relates to a breakover diode, and more particularly to a breakover diode having a low breakover voltage.

Sensitive electronic circuitry can easily be damaged by a voltage or current surge caused by a power supply fault or lightning strike. It is known to provide protection devices which divert the fault current away from the electronic circuitry. Fuses are not sufficient for such applications, because they cannot isolate the fault quickly enough to prevent damage.

One type of semiconductor protection device comprises a self-gating thyristor and is called a breakover diode. This device is rapidly turned on when the voltage across its terminals exceeds a certain reference voltage, so that the fault current is quickly diverted.

Known breakover diodes have breakover voltages generally between 70 and 300 volts. The device can best be represented as consisting of two bipolar transistors, a PNP transistor and an NPN transistor, interconnected in known manner whereby the PNP transistor (connected between the anode and cathode of the device) turns on the NPN transistor, in order to switch the device into its conductive state. The voltage at which this occurs is controlled by the avalanche breakdown voltage of the collector-base junction of the PNP transistor.

This known device has a low on-state resistance, and thus high currents can flow between anode and cathode with a relatively low forward voltage drop across the device.

The breakdown voltage of the collector-base junction of the PNP transistor is inversely proportional approximately to the square root of the carrier concentration in the N type base. Therefore if a low breakdown voltage is required, a high carrier concentration is needed in the N type base.

The device is formed from an N type substrate, into which P type collector and emitter regions are diffused. However, a number of problems arise when a highly doped N type starting silicon is used. Firstly it is virtually impossible to diffuse a deep P type region into such a highly doped N type substrate. Also an $N^+$ layer must be diffused into the already highly doped P type diffusion region, and the PN junction formed tends to have a much higher leakage current than a junction formed in a substrate of lower carrier concentration.

The main problem with the device is that because the base regions of the two transistors are very highly doped, this reduces the minority carrier lifetime in the base. The consequent recombination of carriers in the base regions reduces the current gain $\alpha$ of the transistors and prevents them from turning on.

We have now devised a breakover diode which can be formed with a breakover voltage as low as 15 volts.

In accordance with this invention there is provided a breakover diode comprising a body of semiconductor material having a thyristor formed by an anode region, an anode base region, a cathode base region and a cathode region disposed in that order between anode and cathode electrodes disposed on respective surfaces of said body, the semiconductor body having a trigger region of the same conductivity type as the anode base region but of substantially higher carrier concentration, which trigger region forms a junction with the anode base region and also forms a junction with the cathode base region.

In use, as the voltage between the anode and cathode electrodes increases, the junction between the trigger region and the cathode base region breaks down at a predetermined voltage, with the effect of switching on the thyristor. The trigger region is of higher carrier concentration than the anode base region, so that the trigger junction breaks down at a selected low voltage, but the need is avoided of increasing the carrier concentration throughout the anode base region to undesirable levels.

Preferably the trigger region is formed adjacent the surface of the semiconductor body on which the cathode electrode is formed. Preferably the cathode base region is formed by diffusion from the surface into the anode base region, and the cathode region is formed by diffusion from the same surface into the cathode base region. Preferably the trigger region is formed by diffusion from the same surface at the periphery of the diffused cathode base region.

Preferably the cathode electrode bridges the cathode region and the cathode base region: when the trigger junction breaks down, the trigger current flows through this junction and through the cathode base region directly to the cathode electrode.

Preferably the breakover diode includes two thyristor sections, a pilot thyristor section and a main thyristor section, in which the trigger action described above switches on the pilot thyristor and then the pilot thyristor (once it has been switched on by the trigger action) switches on the main thyristor. In embodiments which will be described herein, the pilot and main thyristors share the same anode region, anode base region and cathode base region, but have respective cathode regions. The pilot thyristor has a cathode electrode which bridges its cathode region and the common cathode base region: when the pilot thyristor switches on, current flows from the anode electrode to its cathode electrode and then into the cathode base region for the main thyristor.

In the embodiments to be described herein, the area of the pilot thyristor is substantially smaller than the area of the main thyristor. The relatively small current which flows when the trigger junction breaks down is able to turn on the small-area pilot thyristor quickly: then the larger current which flows through the pilot thyristor is able to turn on the large-area main thyristor quickly.

In one preferred embodiment, a zener diode is formed at the anode of the device by an additional region provided between the anode electrode and anode region and of opposite conductivity type to the latter. The device breaks down when the applied voltage exceeds the zener voltage plus the breakdown voltage of the trigger junction: when conductive, the voltage drop across the device is the sum of the zener voltage and the forward voltage drop of the device.

Embodiments of the invention will now be described by way of examples only and with reference to the accompanying drawings, in which:

Figure 1 is a section through a breakover diode in accordance with this invention;

Figure 2 is a similar section through the device of Figure 1, showing avalanche current flowing when a trigger section of the device breaks down;

Figure 3 is a similar section through the device of figure 1, showing triggering of a pilot thyristor of the device;

Figure 4 is a similar section through the device of Figure 1, showing current flowing through the pilot thyristor;

Figure 5 is a similar section through the device of Figure 1, showing a main thyristor of the device conducting full fault current; and

Figure 6 is a section through another embodiment of the invention, incorporating a zener diode.

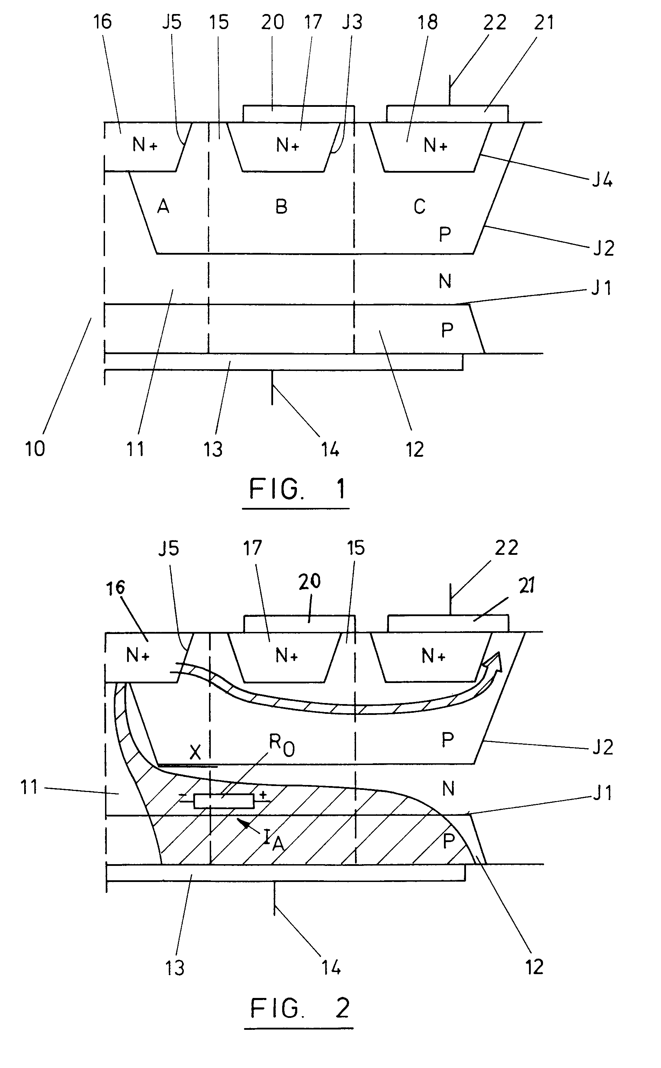

Referring to Figure 1 of the drawings, there is shown a silicon semiconductor substrate 10 of N type. The initial substrate forms an anode base region 11 and a P type anode region 12 is formed on one surface of the device. A conductive electrode 13 is deposited over the P type anode region 12. An anode terminal 14 is connected to the electrode 13.

The opposite side of the device is formed with a P type cathode base region 15 diffused into the N type substrate, i.e. into the anode base region 11. A highly doped $N^+$ type trigger region 16 is diffused into the same surface of the device into the junction of the P and N type regions 15, 11. A second $N^+$ type region 17 is diffused into the P type region 15 from the same surface. Similarly a third $N^+$ type region 18 is formed in the P type region 15. Conductive contacts or electrodes 20, 21 are deposited on the surface of the device over the two $N^+$ type regions 17, 18 respectively. Both contacts 20, 21 also contact the P type region 15. A cathode terminal 22 is connected to the electrode 21 formed on the third $N^+$ type region 18.

The device may be considered as comprising three sections, a trigger section A, a pilot thyristor section B and a main thyristor section C: the cross-sectional area of the pilot thyristor is substantially smaller than the area of the main thyristor.

The breakover triggering action of the device is initiated by avalanche breakdown of the PN junction J5 between the trigger 16 and the cathode base region 15. Unlike the collector-base junction of the prior art device, J5 is a double diffused junction formed by an $N^+$ diffusion 16 into the previously diffused P layer 15. The carrier concentration of the starting silicon wafer is not therefore important in determining the reference voltage of the device; it is instead controlled by the two diffusion regions 15, 16.

In use when a positive bias is applied to the anode 14 with respect to the cathode 22, the PN junction J1 is forward biased, and the PN junctions J2 and J5 are reverse biased. No conduction occurs between the anode 14 and cathode 22 except for leakage across the reverse biased junction J2 and J5. The full applied voltage will appear across these reverse biased junctions.

Avalanche breakdown of a junction first occurs where the electric field is the greatest, and thus the PN junction J5 breaks down at the surface of the device, because the P type carrier concentration in this zone is higher than elsewhere along the PN junction J5, and much higher than the carrier concentration at J2. The breakdown voltage of the junction J5 is therefore much lower than the junction J2, and thus it is this junction J5 that is designed to breakdown at the desired trigger voltage of the device.

Wherever the anode-cathode voltage of the device exceeds the avalanche breakdown voltage of the junction J5, current $I_a$ flows as shown in Figure 2. This current also serves as a base current for the PNP transistor, thus transistor action will take place, injecting further holes into the cathode base region 15 due to lateral voltage drop in the anode base region 11 because of the inherent resistivity of this region, represented by a series resistor $R_o$. This transistor action will occur mainly towards the centre of the device i.e. at zone X.

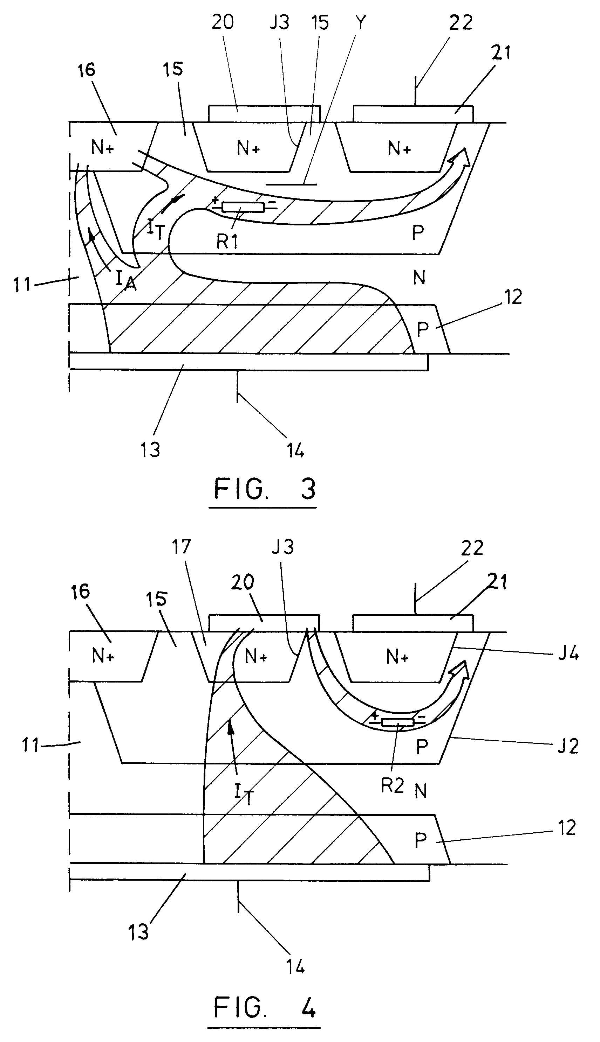

The pilot thyristor section B can be considered as two transistors, a PNP transistor formed by regions 12, 11, 15 and an NPN transistor formed by regions 17, 15, 11. Figure 3 shows the anode-cathode current of the device as comprising transistor action current $I_T$ and avalanche current $I_A$.

The P type cathode base region 15 also has inherent resistivity, as represented by a resistor R1. Therefore the current flowing either through junction J5 or through zone X and through the cathode base region 15 to the cathode terminal 22 will cause a voltage drop in the cathode base region 15 beneath the PN junction J3.

The conductive layer 20 formed on the $N^+$ type region 17 shorts the surface of the cathode base region 15 to the $N^+$ region 17, acting as the emitter of the second transistor of the pilot thyristor. Owing to the inherent resistance R1 of the P base, the potential of the P type region 15 at Y rises and eventually the junction J3 becomes significantly forward biased and electrons are injected across the emitter-base junction J3 of the NPN transistor 17,15,11.

The current gain of the NPN transistor 17,15,11 has a current gain $\alpha_{NPN}$, and the PNP transistor 12, 11, 15 has a current gain $\alpha_{PNP}$. Whenever $\alpha_{NPN} + \alpha_{PNP}$ = 1 the pilot thyristor B will switch into its conductive state, with current flowing through it from anode 14 to contact 20, then from contact 20 across J3 into P type region 15 and through the latter to cathode 22, as shown in Figure 4. Thus there is now an increased current flowing through the device from its anode 14 to its cathode 22.

The increased current under junction J4 causes electrons to be injected into the cathode base region 15 in a similar way to the pilot thyristor section. This is due again to the resistivity of the P type region 15 under the junction J4, represented in Figure 4 by a resistance R2.

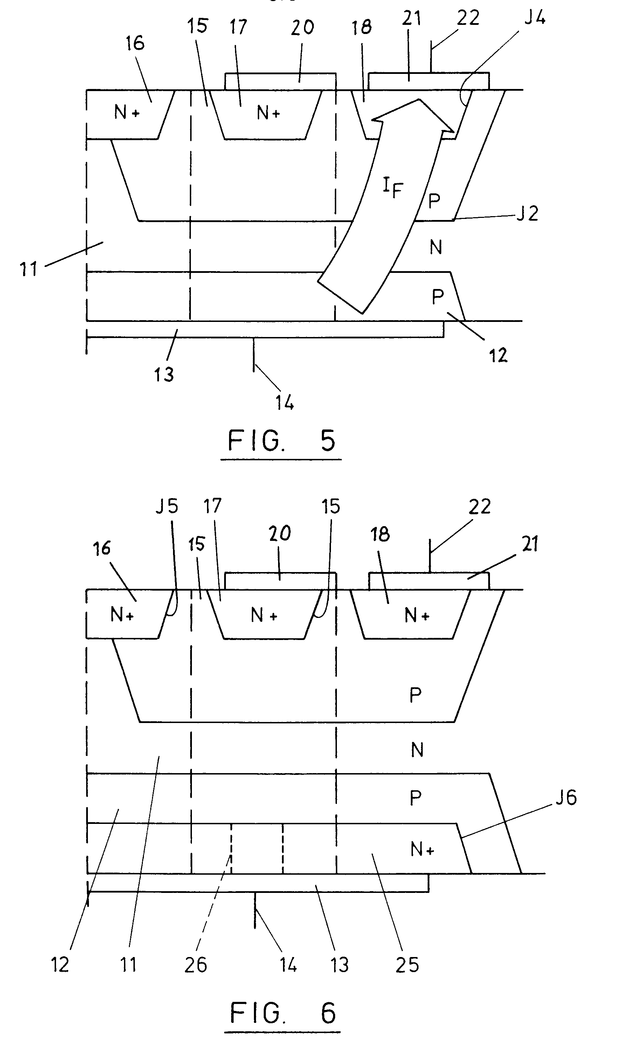

Once the main thyristor has been triggered, full fault current $I_f$ flows from anode 14 to cathode 22 as shown in Figure 5. The central junction J2 is now forward biased and the voltage drop across the device is of the order of 1 to 1.5 volts. Whenever the main thyristor section C switches on it carries all the device current thereby relieving the stress on the pilot thyristor B and avalanche junction J5.

Figure 6 shows another embodiment of the device, wherein an extra $N^+$ layer 25 is formed on the underside of the device. The PN junction formed between the layers 12 and 25 act as a zener diode. In use, as the voltage on the anode 14 is increased, the device does not conduct until the clamp voltage is reached. This voltage is given by the sum of the breakdown voltages of junctions J5 and J6. At this point the device conducts current through the trigger region 16 into the cathode base region 15. The device now operates in the same way as the previous embodiment.

Owing to the zener diode created by the $N^+$ layer 25 at the anode 14, when the main thyristor is fully on, the voltage drop across the device will be the sum of the zener voltage and the forward voltage drop between anode region 12 and the cathode. Therefore the total voltage drop of the device (the return voltage) can be selected at the design stage by selection of the zener voltage. The breakdown voltage for the avalanche region J5 determines the difference between the return and clamp voltages.

In a modification of the device shown in Figure 6, a P type region 26 is formed through the $N^+$ region 25 from the anode electrode 13 to the anode region 12, in order to form a high value resistor. This then allows the potential at the anode to be applied across the junction J5 before the zener breaks down: once the zener does break down, the majority of the current flows through the zener and only a small current flows through the high value resistor.

In the examples shown, the anode region is formed by diffusion into the lower side of the N type substrate 11. Instead, the anode region may be formed from a separate P type silicon substrate and then bonded onto the N type substrate 11: in the example having the zener, the additional $N^+$ region will be diffused into the separate P type substrate before it is silicon-bonded to the main substrate 11. These methods of construction lead to an improvement in the current rating of the device.

## Claims

1) A breakover diode comprising a body (10) of semiconductor material having a thyristor formed by an anode region (12), an anode base region (11), a cathode base region (15) and a cathode region (18) disposed in that order between anode and cathode electrodes (13,21) disposed on respective surfaces of said body (10), the semiconductor body (10) having a trigger region (16) of the same conductivity type as the anode base region (11) but of substantially higher carrier concentration, which trigger region (16) forms a junction with the anode base region (11) and also forms a junction (J5) with the cathode base region (15).

2) A breakover diode as claimed in claim 1, in which the trigger region (16) is formed adjacent the surface of the semiconductor body on which the cathode electrode (21) is formed.

3) A breakover diode as claimed in claim 1 or 2, in which the cathode electrode (21) bridges the cathode region (18) and the cathode base region (15).

4) A breakover diode as claimed in any preceding claim, comprising a pilot thyristor section (B) and a main thyristor section (C), arranged for the pilot thyristor section to be switched on upon breakdown of said junction (J5) between the trigger region (16) and the cathode base region (15), and for the main thyristor section to be switched on upon conduction of the pilot thyristor section.

5) A breakover diode as claimed in claim 4, in which the pilot and main thyristor sections share the same anode region (14), anode base region (11) and cathode base region (15), but have respective cathode regions (17,18).

6) A breakover diode as claimed in claim 5, in which the pilot thyristor section comprises a cathode electrode (20) which bridges its cathode region (17) and the common cathode base region (15).

7) A breakover diode as claimed in any preceding claim, in which the area of the pilot thyristor section is substantially smaller than the area of the main thyristor section.

8) A breakover diode as claimed in any preceding claim, comprising an additional region (25) disposed between the anode electrode (13) and the anode region (12), said additional region (25) being of opposite conductivity type to the anode region (12) and providing a zener diode at the anode of the device.

9) A breakover diode as claimed in claim 8, in which a further region (26) is formed through the additional region (25) from the anode electrode (13) to the anode region (12), said further region (26) being of the same conductivity type as the anode region (12).

10) A breakover diode as claimed in any preceding claim, in which the cathode base region (15) is formed by diffusion from a surface of the semiconductor body (10) into the anode base region (11), the cathode region (17,18) is formed by diffusion from the same surface into the cathode base region (15), and the trigger region (16) is formed by diffusion from the same surface at the periphery of the diffused cathode base region (15).

FIG. 1

FIG. 2

FIG. 3

FIG. 4

16  15  17  20  18  21  22  J4

N+    N+    I_F    P    J2
11                              N
                    P
                              12
13
14

FIG. 5

J5  17  15  22
16  15  20  18  21

N+    N+    N+
                    P
                    N
                    P    J6
                    N+
12  11  26  14  13  25

FIG. 6

European Patent
Office

**EUROPEAN SEARCH REPORT**

Application Number

EP 92 30 2367

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN vol. 13, no. 437 (E-825)(3785) 29 September 1989 & JP-A-1 165 170 ( NEC ) 29 June 1989 | 1-3,10 | H01L29/86 |
| Y | * abstract * | 4-9 | |
| X | GB-A-1 102 836 (WESTINGHOUSE) * page 2, left column, line 3 - line 37; figures * | 1-3,10 | |
| Y | EP-A-0 108 961 (TOKYO SHIBAURA DENKI KABUSHIKI) * page 3, line 32 - page 7, line 25; figures 1,2 * | 4-7 | |
| A | | 3 | |
| Y | GB-A-2 208 257 (TEXAS INSTRUMENTS) * page 5, line 14 - line 20; figures 1,2 * | 8,9 | |
| A | WO-A-8 706 768 (THOMSON) * abstract; figures * | 1-10 | |
| A | DE-A-2 022 925 (NORTHERN ELECTRIC COMPANY) * figures * | 8,9 | TECHNICAL FIELDS SEARCHED (Int. Cl.5) |
| A | US-A-4 325 074 (OSADA) * figure 6 * | 8,9 | H01L |
| A | US-A-4 286 279 (HUTSON) * abstract; figures * | 8,9 | |

The present search report has been drawn up for all claims

| Place of search | Date of completion of the search | Examiner |
|---|---|---|
| THE HAGUE | 06 JULY 1992 | VENDANGE P. |

EPO FORM 1503 03.82 (P0401)